(19) Europäisches Patentamt
European Patent Office
Office européen des brevets

(11) **EP 0 946 780 B1**

(12) **EUROPÄISCHE PATENTSCHRIFT**

(45) Veröffentlichungstag und Bekanntmachung des Hinweises auf die Patenterteilung:
**16.01.2002 Patentblatt 2002/03**

(21) Anmeldenummer: **97948671.9**

(22) Anmeldetag: **23.12.1997**

(51) Int Cl.⁷: $C23C\ 14/56$

(86) Internationale Anmeldenummer:
**PCT/CH97/00481**

(87) Internationale Veröffentlichungsnummer:
**WO 98/28460 (02.07.1998 Gazette 1998/26)**

(54) **VAKUUMBEHANDLUNGSANLAGE**

VACUUM TREATMENT EQUIPMENT

INSTALLATION DE TRAITEMENT SOUS VIDE

(84) Benannte Vertragsstaaten:
**AT CH DE ES FR GB IT LI NL SE**

(30) Priorität: **23.12.1996 CH 317896**

(43) Veröffentlichungstag der Anmeldung:
**06.10.1999 Patentblatt 1999/40**

(73) Patentinhaber: **Unaxis Balzers Aktiengesellschaft**
**9496 Balzers (LI)**

(72) Erfinder: **SCHERTLER, Roman**
**A-6922 Wolfurt (AT)**

(74) Vertreter: **Troesch Scheidegger Werner AG**
**Patentanwälte Postfach**
**8032 Zürich (CH)**

(56) Entgegenhaltungen:
**EP-A- 0 136 562      EP-A- 0 555 764**
**EP-A- 0 591 706**

- **PATENT ABSTRACTS OF JAPAN vol. 096, no. 002, 29.Februar 1996 & JP 07 286273 A (SHIBAURA ENG WORKS CO LTD), 31.Oktober 1995,**

**Beschreibung**

Die vorliegende Erfindung betrifft Vakuumbehandlungsanlagen jeweils nach dem Oberbegriff von Anspruch 1 oder 2 bzw. eine Vakuumkammer nach Anspruch 19.

Aus der EP-0 136 562 ist eine Vakuumbehandlungsanlage der im Oberbegriff von Anspruch 1 definierten Art bekannt. Die am Innengehäuse, ausgerichtet auf die vorgesehenen Behandlungskammern bzw. deren Öffnungen vorgesehenen Vorschubeinrichtungen mit radial getrieben beweglichen Stösseln als Mitnehmer, werden durch einen gemeinsamen zentralen Keilantrieb, mechanisch reibend, synchron und hubgleich angetrieben.

Nachteilig bei diesem Vorgehen ist, dass es nicht möglich ist, den Vorschub für verschiedene der vorgesehenen Behandlungskammern unterschiedlich auszulegen, wie beispielsweise zur Befolgung unterschiedlicher Dichtungsanforderungen. Im weiteren wird ein jeweiliger vorgesehener Stössel auch dann betätigt, wenn an der ihm zugeordneten Öffnung gar keine Behandlungskammer vorgesehen ist, indem beispielsweise mit der vorbekannten Anlage flexibel ein weniger Behandlungsschritte notwendig machender Prozess gefahren werden soll.

Auch wenn beispielsweise eine der Behandlungskammern eine Vorschubbewegung des Werkstückes gegen ihre Öffnung hin gar nicht erforderte, wie z. B. eine Heizkammer, wird an der vorbekannten Anlage ein Vorschubhub auch dort ausgeführt.

Unter einem ersten Aspekt ist es Aufgabe der vorliegenden Erfindung, diese Nachteile zu beheben. Dies wird ausgehend von einer Anlage der im Oberbegriff von Anspruch 1 definierten Art durch deren Ausbildung nach dem Kennzeichen von Anspruch 1 gelöst, d. h. dadurch, dass jeder Mitnehmer einen eigenen Antrieb aufweist.

Ein weiterer wesentlicher Nachteil der aus obgenannter Schrift vorbekannten Anlage ist es, dass die Stösselhubbewegungen keilgetrieben sind. Damit ist der Hub verschleissabhängig. Bei der vorbekannten Anlage werden, durch den erwähnten Stösselhub, Werstückträgerplatten vom Karussell gegen die jeweiligen Öffnungen angehoben und dort dichtend an den Öffnungsrand gelegt.

Wenn der Hub an der vorbekannten Anlage verschleissbedingt auch nur wenig ändert, ändern sich die angestrebten Dichtungsverhältnisse mit, was bei gewissen heikeln Bearbeitungsprozessen nicht tolerabel ist.

Unter Dichten wird im Rahmen der gesamten vorliegenden Anmeldung sowohl berührungsloses Dichten, wie durch Bilden einer Druckstufe über eine Labyrinthdichtung verstanden, sowie auch form- und/oder kraftschlüssiges Dichten.

Unter diesem Aspekt sei auch auf die EP-A-0 555 764 verwiesen. Daraus ist eine Vakuumbehandlungsanlage bekannt, die zylinderförmig ausgebildet ist. Sie umfasst einen äusseren stationären Zylindermantel und einen inneren, um die Zylinderachse drehbaren Teil. An diesem sind, sternförmig, gegen den Zylindermantel hin offene Kammern mit Pumpanschlüssen angebracht, die durch jeweilig berandende Wandungen gebildet sind. Am stationären Zylindermantel seinerseits sind nach innen offene Bearbeitungsräume angebracht, derart, dass durch Drehen des inneren, drehbaren Teils die gegen aussen offenen Kammern auf die nach innen offenen Bearbeitungsräume ausgerichtet werden können. Mittels hydraulisch bzw. pneumatisch aktivierbarer Dichtungen können die Berandungen der Oeffnungen, einerseits der Kammern, anderseits der Bearbeitungsräume, dicht verbunden werden und bilden dann gemeinsam Bearbeitungskammern, über die erwähnten Pumpanschlüsse an den Bearbeitungsräumen konditionierbar und zu behandelnde Werkstücke enthaltend.

Im weiteren kann auf die EP 0 591 706 verwiesen werden, woraus eine Vakuumbehandlungsanlage bekannt ist, bei der ein innerer, drehbarer Teil mehrere Stössel mit endständigen, tellerförmigen Werkstückaufnahmen hat. Die für sich je ausfahrbaren bzw. rückholbaren Stössel werden durch Drehen des inneren Teils in Ausrichtung zu an der Aussenwandung der Anlage vorgesehenen, nach innen offenen Behandlungsstationen gebracht und dann die randständig planen Werkstückaufnahmeteller selektiv gegen die jeweiligen Behandlungsstationen hin ausgefahren.

Unter einem zweiten Aspekt der vorliegenden Erfindung wird nun von der Aufgabe ausgegangen, die obgenannten Dichtungsprobleme, ausgehend von einer Anlage gemäss der EP 0 136 562 - d.h. mit einem Aussengehäuse, das eine um eine Achse im wesentlichen zylindrische Innenwand definiert, mit mindestens zwei Öffnungen zur Behandlung oder für den Durchtransport jeweils eines Werkstücks entlang mindestens eines Grosskreises der zylindrischen Innenwand, je einer Oberflächen-Behandlungs-, Transport- oder Schleusenkammer, mit den Öffnungen verbunden - zu lösen. Dies wird bei Realisation der Vakuumbehandlungsanlage nach dem Kennzeichen von Anspruch 2 erreicht.

Dabei umfasst mindestens eine der Öffnungen eine fluidgesteuerte, vorzugsweise eine pneumatisch oder hydraulisch gesteuerte Dichtungsanordnung - eine aktive Dichtung -, mittels welcher eine um die Öffnung umlaufende Dichtung zwischen Öffnungsberandung und einer Werkstückaufnahme oder einem Werkstück selber erstellt bzw. gelöst wird. Dadurch wird erreicht, dass grundsätzlich das Ausmass der vorzusehenden Dichtung immer konstant gleichbleibend erhalten werden kann, weil aufgrund der pneumatischen oder hydraulischen Ansteuerung ein jeweils vorgesehener Dichtungsdruck unabhängig von mechanischen Einflüssen wird.

Bevorzugte Ausführungsformen der erfindungsgemässen Vakuumbehandlungsanlage sind in den Ansprüchen 3 bis 14 spezifiziert, deren Verwendung in den Ansprüchen 15 bis 17.

Im weiteren werden die oben angesprochenen Dichtungsprobleme in noch vorteilhafterer Form an einer Vakuumkammer nach dem Wortlaut von Anspruch 18 gelöst. Es spezifizieren die Ansprüche 19 bis 39 deren bevorzugte Ausführungsvarianten. Eine bevorzugte Kombination einer Vakuumbehandlungsanlage oben erwähnter Art mit einer Vakuumkammer eben erwähnter Art ist in Anspruch 40 spezifiziert, Verwendungen der Vakuumkammer bzw. deren Einsatz an einer Vakuumbehandlungsanlage in den Ansprüchen 41 bis 43.

Die Vakuumkammer nach Anspruch 18, die, wie zu erläutern sein wird, keine oder nur geringe Abhebe-Hube der Werkstückträger von Behandlungsöffnungen bzw. Transportöffnungen in der Wand der Vakuumkammer erfordert, eignet sich ganz besonders für den Einsatz der erwähnten, aktiven Dichtungen.

Die Erfindung wird anschliessend beispielsweise anhand von Figuren erläutert. Es zeigen:

Fig. 1    schematisch eine erfindungsgemässe Anlage unter dem ersten Aspekt;

Fig. 2    ausgehend von der Darstellung gemäss Fig. 1 eine bevorzugte fluid-, vorzugsweise pneumatisch oder hydraulisch getriebene Mitnehmeranordnung anhand einer vergrösserten Ausschnittsdarstellung eines Mitnehmer-Bereiches;

Fig. 3    schematisch eine Dichtungsanordnung im Öffnungsbereich einer Behandlungskammer unter dem zweiten Aspekt der vorliegenden Erfindung;

Fig. 4    schematisch eine bevorzugte Ausführungsform der Dichtung nach Fig. 3;

Fig. 5    schematisch die Aufsicht auf einen Aussengehäuse-Ausschnitt einer Anlage;

Fig. 6    eine Schnittdarstellung durch einen Abschnitt des Anlageaussengehäuses, wie schematisch in Fig. 5 dargestellt und geschnitten entlang der Line I-I;

Fig. 7    einen Querschnittsausschnitt durch eine bevorzugte Ausführungsform einer erfindungsgemässen Anlage in vereinfachter Darstellung;

Fig. 8    eine Längsschnittdarstellung durch einen Teil einer erfindungsgemässen Anlage in bevorzugter Ausführungsform;

Fig. 9    eine Querschnittsdarstellung durch einen Teil einer erfindungsgemässen Anlage gemäss Fig. 8 in einer weiteren bevorzugten Ausführungsform;

Fig. 10    in perspektivischer Darstellung, die Verhältnisse zwischen einem ebenen Werkstückträger und der zylindrischen Umrandungsfläche einer mit dem Werkstückträger zu bedienenden Öffnung bekannter Art;

Fig. 11    die Verhältnisse gemäss Fig. 10 in Aufsicht zur Erläuterung der notwendigen Abhebhub-Bedingungen;

Fig. 12    in Darstellung analog zu Fig. 10 die Verhältnisse bei erfindungsgemässer Formgebung von Öffnungsumrandung und Werkstückträger-Umrandung;

Fig. 13    die sich dadurch bezüglich Abhebehub ergebenden Konsequenzen;

Fig. 14    eine erfindungsgemässe Anlage in Längsschnitt-Darstellung mit kugelringförmiger Kammerwand;

Fig. 15    in Querschnitts-Darstellung die Anlage gemäss Fig. 14;

Fig. 16    in Darstellung analog zu Fig. 14 eine erfindungsgemässe Anlage mit Aktivdichtungen;

Fig. 17    in Seitenansicht mehrere der erfindungsgemässen Kammern, gemäss den Figuren 14 und 15 bzw. vorzugsweise 16 modular gestapelt;

Fig. 18    an der Anlage gemäss Fig. 19 eine erfindungsgemässe Öffnungsumrandungsfläche und Werkstückträger-Formung ausserhalb der Kammer.

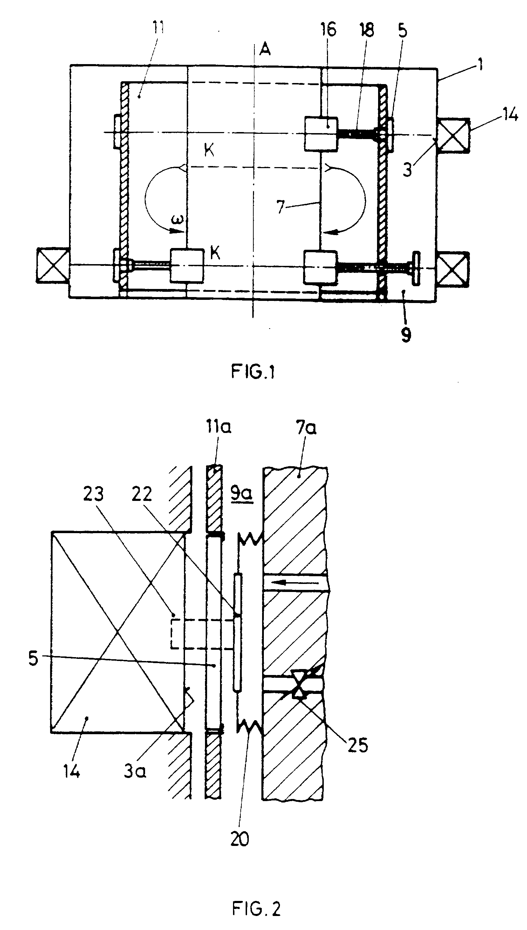

In Fig. 1 ist, rein schematisch, eine Anlage dargestellt grundsätzlich der in der EP-A-0 136 562 vorbekannten Art, aber gemäss dem ersten Aspekt der vorliegenden Erfindung weitergebildet.

An einem im wesentlichen um eine Achse A zylindrisch ausgebildeten Aussengehäuse 1 sind entlang mindestens eines, wie dargestellt entlang zweier Grosskreise K, Öffnungen 3 zum Durchtransport oder zur Behandlung von Werkstücken 5 vorgesehen. An den Öffnungen 3 sind Behandlungskammern angeordnet, worunter generell Beschichtungs-, Ätz-, Kühl-, Heiz-, Transport- oder Schleusenkammern verstanden seien, dabei vorzugsweise mindestens eine Oberflächenbehandlungskammer, vorzugsweise Plasma-Oberflächenbehandlungskammer, dabei weiter vorzugsweise Zerstäubungskammer, insbesondere mit einer Magnetronquelle.

Gemeinsam mit der Innenwand des Aussengehäuses 1 bildet die Aussenwand eines Innengehäuses 7, ebenfalls im wesentlichen bezüglich der Achse A zylindrisch, eine ringförmige Transportkammer 9. Darin ist, bezüglich der Achse A drehgetrieben, ein Karussell 11 vorgesehen, woran, entlang der erwähnten Grosskreise K, die Werkstücke 5, dabei bevorzugterweise scheibenförmige Werkstücke, abgelegt und gehaltert sind. Bevorzugterweise handelt es sich um Speicherplatten, wie CD, DVD, HD, insbesondere um wiederbeschreibbare Speicherplatten wie MOD, Phase-Change-Disks und RC (Recordable Disks). Durch die Drehbewegung des Karussells 11 um die Achse A werden die Werkstücke 5 auf ein oder mehreren Grosskreisen K sukzessive gegenüber Öffnungen 3 der jeweiligen Kammern 14 positioniert. Am Innengehäuse 7 sind erfindungsgemäss, je den Öffnungen 3 gegenüberliegend, Antriebe 16 vorgesehen, mittels welcher Stössel 18 als Mitnehmer radial gegen die Öffnungen 3 hin bewegt bzw. von letzteren zurückgeholt werden. Ob direkt oder indirekt, z.B. über einen (hier nicht dargestellten) Aufnahmeteller, wirken die Stössel 18 auf die entsprechend positionierten Werkstücke 5, und ihr Vorschub bewegt die Werkstücke 5 in gefordertem Masse zu den Öffnungen 3 hin bzw. von letzteren zurück. Jeder der Antriebe 16 kann einerseits, wann immer erwünscht, aktiviert werden, und anderseits kann sein Hub spezifisch so ausgelegt werden, wie es die jeweilige Bearbeitung an der jeweiligen Kammer 14 erfordert. Ist die Kammer 14 beispielsweise eine Schleusenkammer, so kann am entsprechenden Antrieb 16 ein etwas grösserer Hub erforderlich sein als an andern Kammern, um eine höheren Anforderungen genügende Abdichtung im Öffnungsbereich 3 zu erzielen.

Wie aus Fig. 1 somit ersichtlich, wird jeder der vorgesehenen Stössel mit einem eigenen Antrieb 16 versehen. In Fig. 1 werden Werkstücke vom Karussell an zwei Grosskreisen K jeweils zugeordneten Kammern 14 zugeführt, wobei in den meisten Fällen Kammern 14 nur entlang einem Grosskreis K vorgesehen werden mit entsprechender Auslegung von Karussell 11 und Antrieben 16.

Es ist durchaus möglich, an der Kammer gemäss Fig. 1 wohl Behandlungskammern 14 entlang mehrerer Grosskreise K vorzusehen, das Karussell 11 aber nur so auszulegen, dass Werkstücke 5 entlang eines einzigen Grosskreises K angeordnet werden, dann aber das Karussell 11 auch axial, d.h. in Richtung der Achse A auf- und abzuverschieben, um beispielsweise die Werkstücke erst an den Behandlungskammern 14 am einen Grosskreis K, dann an den Behandlungskammern 14 entlang eines zweiten Grosskreises K vorbeizuführen.

Die Antriebe 16 gemäss Fig. 1 können magnetisch, elektromotorisch fluidgetrieben, dabei pneumatisch oder hydraulisch sein, vorzugsweise pneumatisch.

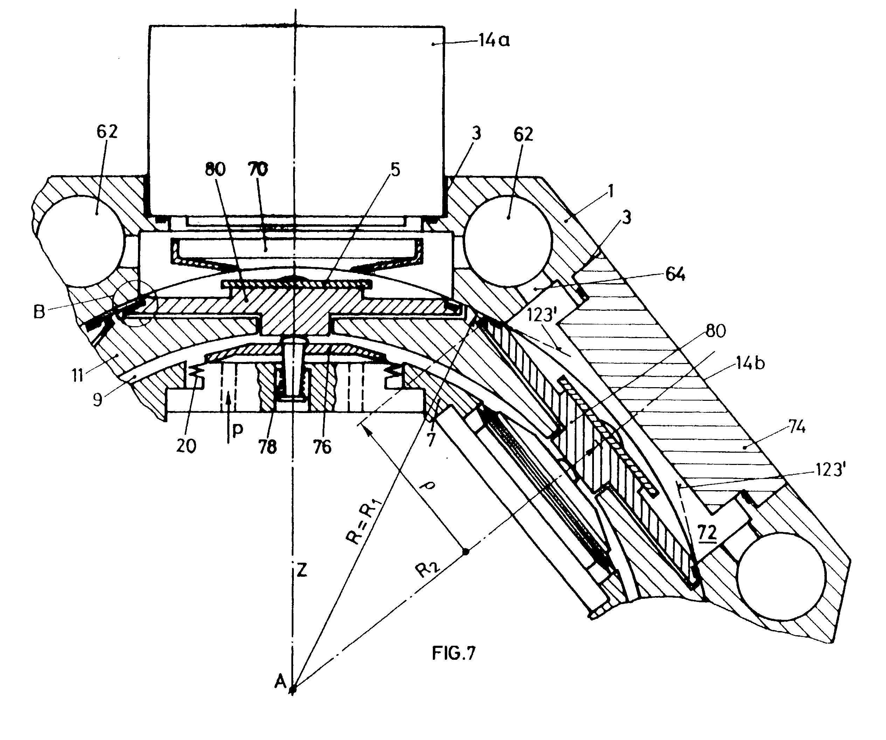

Bezüglich bevorzugter Ausbildung der Umrandungsflächen der Öffnungen 3 und der Umrandungsflächen von Werkstückträgern (nicht dargestellt) für die Werkstücke 5 wird auf die Figuren 7 bis 9 und 10 bis 13 und diesbezügliche, noch folgende Beschreibung verwiesen: Dadurch werden geringstmögliche Hubbewegungen der Stössel 18, falls überhaupt vorzusehen, möglich.

Eine bevorzugte Ausführungsform eines Antriebes 16 gemäss Fig. 1 ist schematisch in Fig. 2 dargestellt. Es muss betont werden, dass ein derartiger Antrieb, d.h. generell eine solche fluidgesteuerte, insbesondere pneumatische oder hydraulische Dichtungssteuerung auch an andersgearteten Vakuumbehandlungsanlagen als der in Fig. 1 gezeigten eingesetzt werden kann, nämlich überall dort, wo angestrebt wird, ein Werkstück der Öffnung einer Behandlungskammer zuzuführen, dabei letztere in erforderlichem Ausmass abzudichten.

Ein pneumatischer Antrieb wird aus vakuumtechnischen Gründen bevorzugt.

Bezüglich der bevorzugten Kombination - Minimalhub und aktive, fluidgesteuerte Dichtung - wird wiederum auf die folgenden Ausführungen zu den Figuren 7 bis 13 verwiesen.

An einer Wand, vorzugsweise einer stationären Gehäusewand 7a, welche einseitig einen Transportraum 9a definiert oder gegebenenfalls an einem ebenfalls beweglichen, nicht weiter dargestellten Transportorgan, beispielsweise für die Bedienung mehrerer Behandlungskammeröffnungen 3a, ist ein dichter Balg 20 vorgesehen, vorzugsweise mit einer Stabilisierungspartie 22 oder einer Eingriffspartie, wie gestrichelt bei 23 dargestellt.

Durch Druckbeaufschlagung des Balgvolumens und dessen Expansion wird das Werkstück 5 von einer Transportanordnung 11a, wie vom Karussell 11 von Fig. 1, gegen die Öffnung 3a angehoben und damit in erforderlichem Masse ein Abdichten des Prozessraumes der Behandlungskammer 14 von der Transportkammer 9a erzielt. Durch Druckentlastung, beispielsweise mittels eines Auslassventils 25 vom Balgraum, wird der gegebenenfalls federgespannte Balg mit dem Werkstück 5 rückgeholt. Damit wird eine fluid-, insbesondere pneumatisch oder hydraulisch betätigbare bzw. steuerbare Dichtungsanordnung im Öffnungsbereich 3a der Behandlungskammer 14 realisiert.

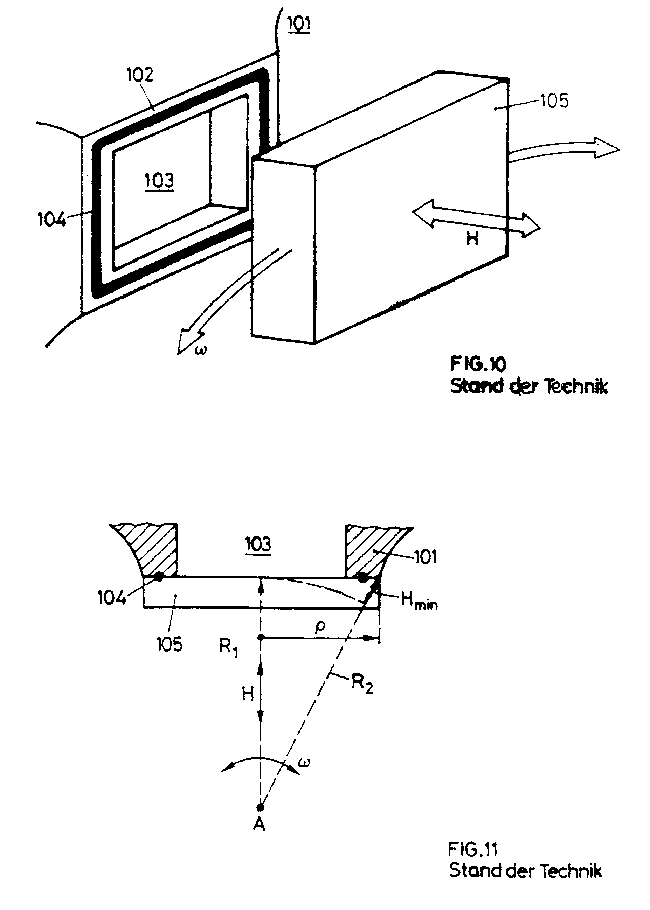

Mit Blick auf Fig. 1 ist ohne weiteres erkenntlich, dass durch Ausbildung der Antriebe 16 von Fig. 1, wie in Fig. 2 schematisch dargestellt, sich eine extrem geringe Baugrösse ergibt, und dass, weiterhin mit Blick auf Fig. 1, die Anordnung der Antriebe nach Fig. 2 modular am Innenzylinder 7, ermöglicht diesen kleinstmöglich auszubilden, weil praktisch im Innenzylinder 7 keine Hublängen aufzunehmen sind, dies insbesondere, wenn dem anhand von den Figuren 10 bis 13 noch zu erläuternden Prinzip gefolgt wird.

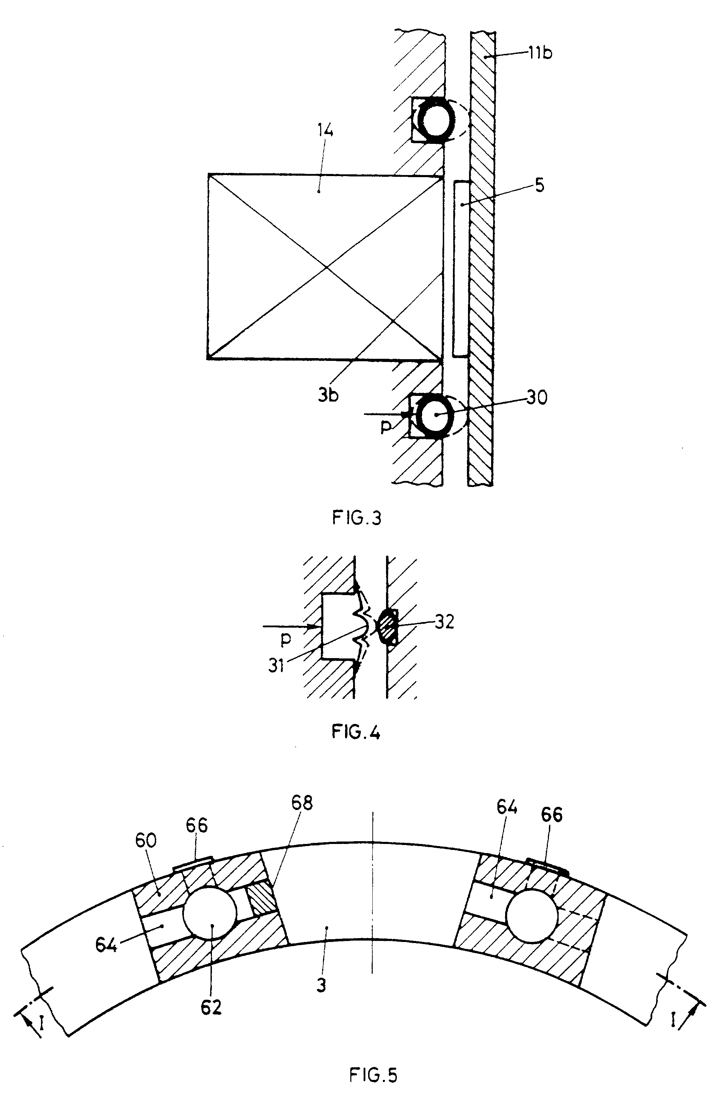

In Fig. 3 ist eine weitere Ausführungsvariante einer hydraulisch oder pneumatisch, vorzugsweise pneumatisch gesteuerten Dichtungsanordnung schematisch dargestellt. Um den Öffnungsbereich 3b einer Behandlungskammer 14 ist ein elastischer Schlauch 30 oder ein elastischer Balg angeordnet und wird, wie mit p dargestellt, gesteuert druckbeaufschlagt. Dabei dehnt sich der Schlauch 30 im Rahmen seiner Eigenelastizität aus und legt sich dichtend an die Transportanordnung 11b für das Werkstück 5 oder, falls dies zulässig ist, direkt an das Werkstück 5 (nicht dargestellt) an. Dabei muss das Werkstück 5 bezüglich der Transportanordnung 11b nicht in Richtung der Öffnung 3b bzw. von ihr weg verschoben werden, was insbesondere gilt, wenn bei einer Drehtransportanordnung 11b das anhand von den Figuren 10 bis 13 erläuterte Prinzip befolgt wird.

Anstelle der wie in Fig. 3 dargestellten Schlauch- bzw. Balganordnung 30 kann die schematisch in Fig. 4 dargestellte Anordnung treten, bei der anstelle des Balges bzw. Schlauches 30 ein metallischer Balg 31 tritt, der gegebenenfalls mit einem Elastomer beschichtet ist. Der gegebenenfalls Elastomer-aussenbeschichtete metallische Balg 31 wird bei seiner, wie mit p wiederum schematisch dargestellt, erfolgenden Druckbeaufschlagung, bevorzugterweise auf eine O-Ring-Anordnung 32 gepresst, die jedoch nicht zwingend vorgesehen werden muss. Die in Fig. 4 dargestellte gesteuerte Dichtungsanordnung erlaubt es, höheren Temperaturbelastungen ausgesetzt zu werden, als die in Fig. 3 dargestellte, indem die Elastizitätswerte der Metallmembrane bzw. des Metallbalges 31 in wesentlich weiteren Temperaturbereichen im wesentlichen konstant bleiben, verglichen mit denjenigen elastischer Schläuche bzw. Bälge 30 aus einem Kunststoff. Damit wird die Anordnung gemäss Fig. 4 vornehmlich in thermisch höher belasteten Bereichen eingesetzt.

In Fig. 5 ist ein Ausschnitt der Aussenwandung bzw. des Aussengehäuses 1 einer erfindungsgemässen Vakuumbehandlungsanlage unter dem dritten Aspekt der vorliegenden Erfindung schematisch dargestellt. Sie umfasst Öffnungen 3 für die Montage der vorbeschriebenen Behandlungskammern. Dazwischen sind, in Richtung von Zylindermantellinien, in die Wandung des Gehäuses 60 Leitungen bzw. Bohrungen 62 eingelassen, welche über Anschlüsse 64 je mit benachbarten Wandpartien, welche die Öffnungen 3 bilden, kommunizieren und mit einem weiteren Anschluss 66 von aussen anschliessbar sind. Selbstverständlich sind die Leitungen 62 oben und unten verschlossen bzw. können z.B. mit Gewindebolzen verschlossen werden, oder die Anschlüsse 66 sind direkt oben bzw. unten an die Bohrungen 62 angesetzt.

Im weiteren können wahlweise auch die Anschlüsse 64, wie schematisch bei 68 dargestellt, wie z. B. mit Schraubbolzen verschlossen werden, so dass eine hohe Flexibilität erreicht wird, mit dem so realisierten Verteilsystem 62, 64, 66, die an den Öffnungen 3 angeschlossenen Behandlungskammern abzupumpen, zu fluten oder gegebenenfalls gaszubeaufschlagen.

Durch die Leitungsanordnung gemäss Fig. 5 werden hohe Leitungsleitwerte erreicht, indem nur sehr kurze Distanzen bei grösstmöglichen Leitungsquerschnitten zwischen externen Anschlüssen und für Behandlungskammern vorgesehene Öffnungen 3 realisiert werden können.

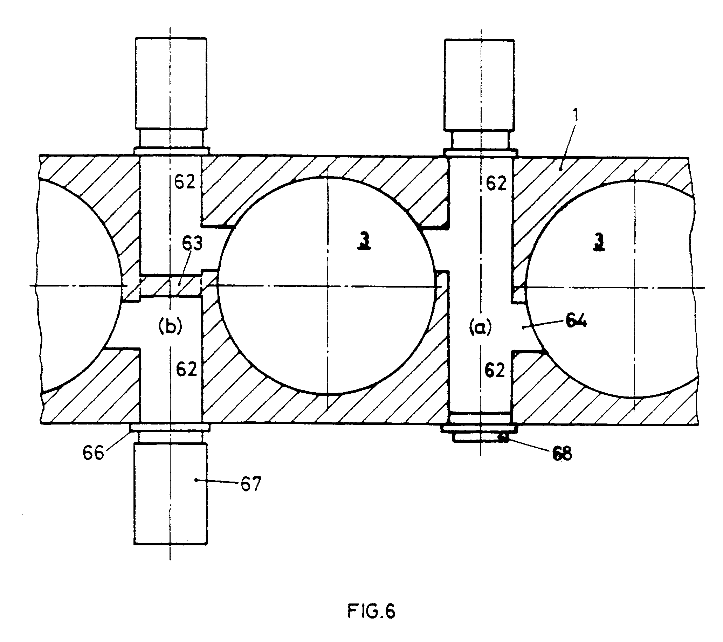

In Fig. 6 ist eine Schnittdarstellung gemäss Linie I-I von Fig. 5 an einer bevorzugten Ausführungsform des Aussengehäuses 1 dargestellt. Es sind dieselben Bezugszeichen wie in Fig. 5 verwendet. In der dargestellten Realisation sind die Anschlüsse 66 direkt stirnseitig der Leitungen 62 vorgesehen. Die Leitungen 62 gehen durch die Ausdehnung des Aussengehäusewand 1 wie bei (a) dargestellt hindurch oder sind wie bei (b) dargestellt als Sachbohrungen ausgebildet oder gegebenenfalls mit einem z.B. einschraubbaren Trennbolzen 63 trennbar. Direkt auf die Anschlüsse 66 werden Aggregate, vorzugsweise Turbovakuumpumpen 67 aufgeflanscht bzw. Abschlussdeckel 68. Wie ersichtlich, ergibt diese Konfiguration eine sehr hohe Flexibilität, externe Aggregate, insbesondere die erwähnten Turbovakuumpumpen 67 aber auch Ventile und/oder weiter Pumpen anzuschliessen.

Das Gehäuse 1 ist dabei massiv, vorzugsweise einteilig ausgebildet. Es besteht vorzugsweise aus Aluminium oder einer Aluminiumlegierung.

Auch das Innengehäuse 7 gemäss Fig. 1 wird vorzugsweise aus den erwähnten Metallen und vorzugsweise dabei auch massiv, vorzugsweise einteilig, ausgebildet.

In Fig. 7 ist ein Teil eines Querschnittes durch eine bevorzugte Ausführungsform einer erfindungsgemässen Behandlungsanlage vereinfacht dargestellt, bei welcher die Aspekte

- jeder Mitnehmer sein Antrieb

- pneumatische Dichtungssteuerung

- optimale Wandungsausnützung für Leitungssysteme

- minimaler Abhebehub (siehe Figuren 10 bis 13)

realisiert sind. Es werden womöglich und zur Erleichterung des Quervergleichs die bereits eingeführten Bezugszeichen für bereits beschriebene Organe und Aggregate eingesetzt.

Das Aussengehäuse 1 weist die Öffnungen 3 zur Aufnahme von Bearbeitungsstationen auf, wie einer Beschichtungsstation 14a und einer Schleusenstation 14b. In den Eckbereichen zwischen den Öffnungen 3 sind die Bohrungen 62 in die Wandung des Aussengehäuses 1 eingearbeitet, mit den Anschlüssen 64 zu den jeweils angrenzenden Öffnungen 3. Die Wandungsdicke des Aussengehäuses 1 ist so bemessen, dass von einer Plasmabeschichtungs- oder Ätzkammer 14a der Prozessraum 70 durch die Aussengehäusewand begrenzt ist bzw. der Schleusenraum 72 an einer Schleusenstation 14b mit äusserem Schleusenventil 74. Das Innengehäuse 7 trägt, den Öffnungen 3 gegenüberliegend, in der in Fig. 2 dargestellten Art betätigbare Stösseleinrichtungen, woran Druckbeaufschlagung eines Balgraumes das Anheben eines Mitnehmers 76 gegen die Rückholkraft einer Zugfeder 78 auslöst. In dem vom Innen- und Aussengehäuse gebildeten, ringförmigen Transportraum 9 ist das Karussell 11 drehbeweglich getrieben angeordnet, mit eingelegten Werkstückträgern 80 für die Werkstückscheiben 5. Durch Anheben der Werkstückträger 80 mittels Aktivieren der pneumatischen Stösselantriebe 20, 76 wird in dem mit B bezeichneten, eingekreisten, um die Öffnung 3 umlaufenden Bereich in erwünschtem Masse abgedichtet. Wie an der Schleusenstation 14b ersichtlich, bildet dabei der Werkstückträgerteller 80 das innere Schleusenventil. Aufgrund der bevorzugten Ausbildung der Umrandungsflächen der Öffnungen 3 und der Werkstückträger 80 sind nur geringe Hubbewegungen der Stösselantriebe 20, 76 notwendig. Zusätzlich können im Bereich B aktive, fluidgesteuerte Dichtungen, bevorzugt wie in Fig. 4 dargestellt, vorgesehen sein.

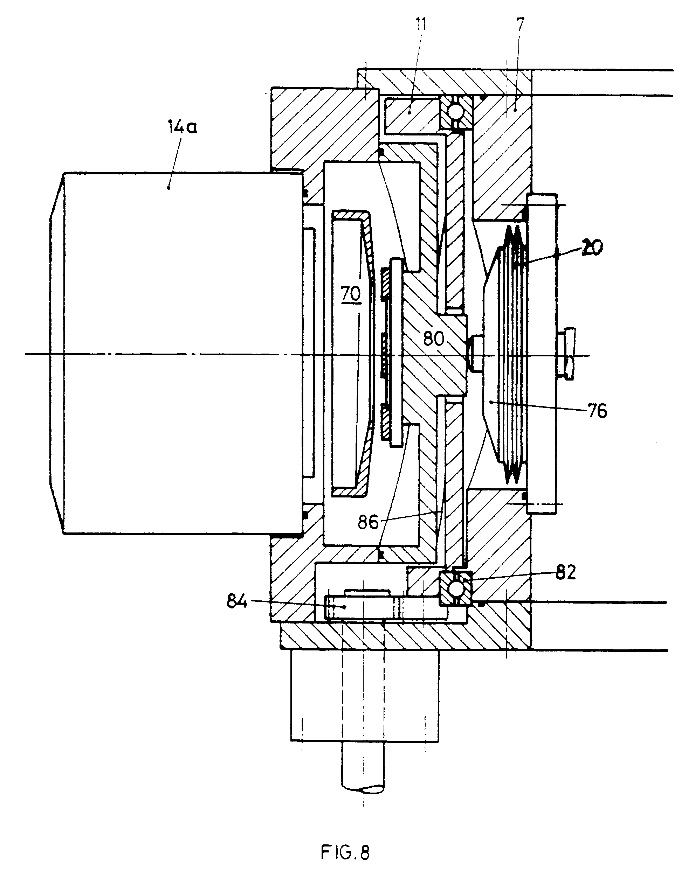

In Fig. 8 ist detaillierter als in Fig. 7 eine Längsschnitt-Darstellung entlang der Achse A von Fig. 7 und durch eine Behandlungs- insbesondere Beschichtungsstation 14a (selber nicht geschnitten) dargestellt. Wiederum sind womöglich dieselben Bezugszeichen eingesetzt für bereits beschriebene Einrichtungen. Zusätzlich zu den Ausführungen gemäss Fig. 7 wird verwiesen auf die Lagerung 82 des Karussells 11 sowie dessen Antrieb bei 84. Im weiteren sind in dieser Darstellung Rückholfedern 86 deutlich ersichtlich, welche, beispielsweise und bevorzugterweise als Blattfedern ausgebildet, den Werkstückträger 80 bei Entlastung und Rückholung des Balges 20 mit Mitnehmer 76 ebenfalls rückholen.

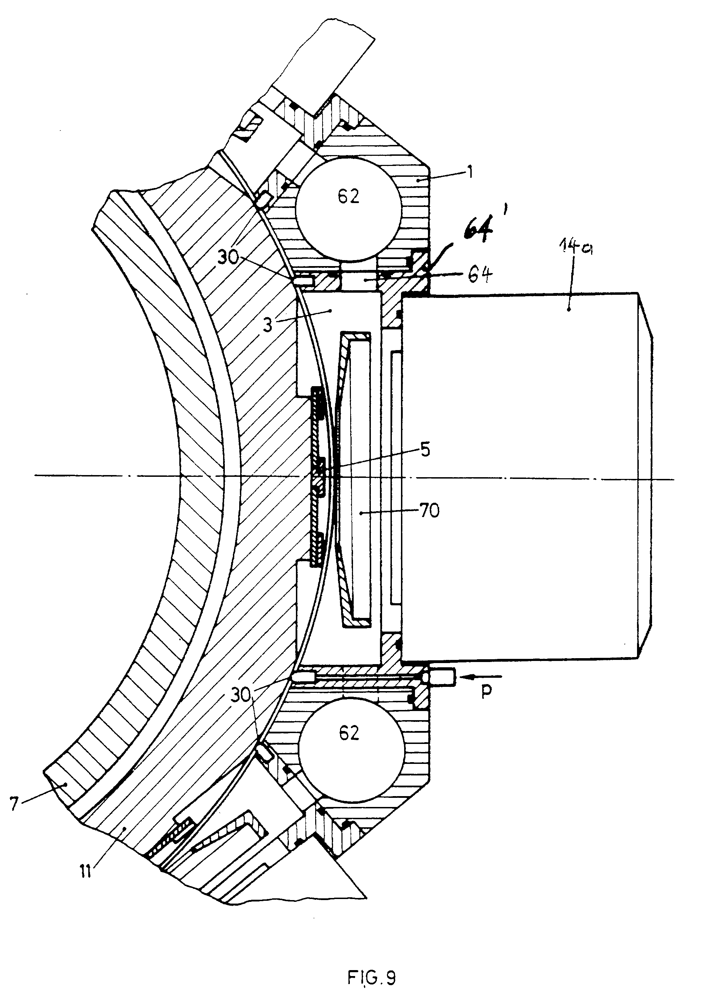

In Fig. 9 ist in einer Schnittdarstellung senkrecht zur Achse A von Fig. 7 eine weitere Ausführungsvariante der bevorzugten Art dargestellt, bei der gemäss Fig. 3 auf die Werkstücke 5 keine radiale Hubbewegung ausgeführt wird. Wiederum sind für bereits vorbeschriebene Einrichtungen dieselben Bezugszeichen eingesetzt. Verwiesen wird hier insbesondere auf die elastischen Dichtungsbälge 30, welche zwischen den Berandungen der Öffnungen 3 und dem Karussell 11 wirken. Wie schon mehrmals erwähnt, können solche umlaufenden Dichtungsbälge 30 oder gemäss Fig. 4 metallischen Dichtungsmembrane 31 durchaus auch auf die Werkstücke 5 direkt wirken, sofern dies bei den betrachteten Werkstücken 5 und der entsprechenden Oberflächenbehandlung zulässig ist. Hier wird die Auslegung der Umrandungsflächen der Öffnungen 3 und des Werkstückträgers in den Bereichen bei 30 gemäss dem noch zu erläuternden Prinzip, insbesondere nach den Figuren 10 bis 13, zur Hubvermeidung besonders deutlich.

Die bis dahin dargestellte Anlage kumuliert nebst noch zu erläuternden vorerst folgende Vorteile:

- optimale Ausnützung des Aussengehäuses für die Leitungsführung zu Behandlungskammern und damit höchst kompakte Bauweise;

- freie Zugänglichkeit vom Innenraum Z des Innengehäuses zu den Steuerorganen und -Antrieben.

Die Figuren 7, 8 und 9 zeigen eine erfindungsgemässe Vakuumbehandlungsanlage, die unter einem weiteren wesentlichen Aspekt höchst vorteilhaft ausgebildet ist.

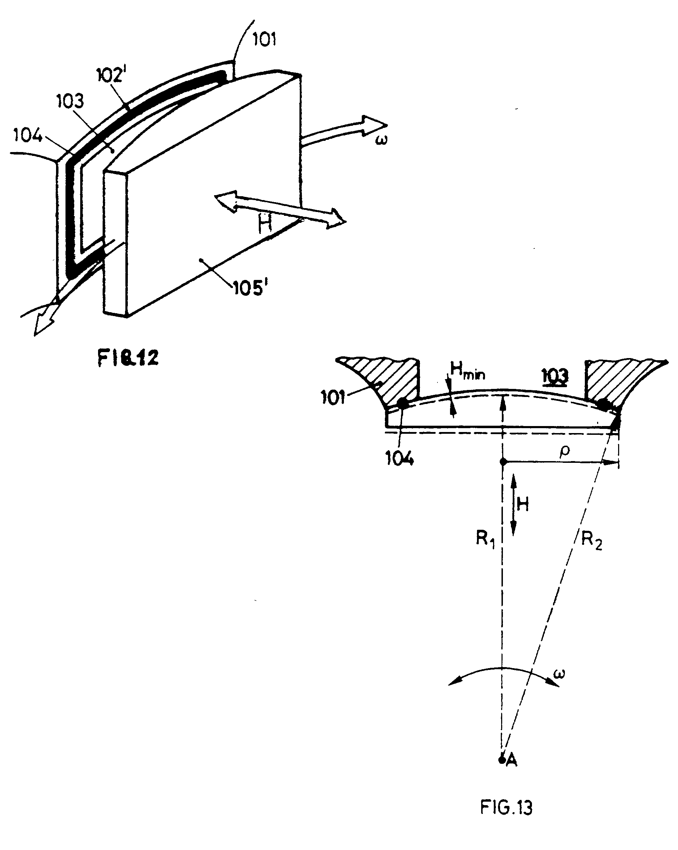

Dies sei vorerst anhand der Figuren 10 und 11 diskutiert.

In Fig. 10 ist eine ebene Umrandungsfläche 102 einer Durchreich- oder Behandlungsöffnung 103 für mindestens ein Werkstück in der Kammerwand 101 dargestellt, mit Dichtung 104.

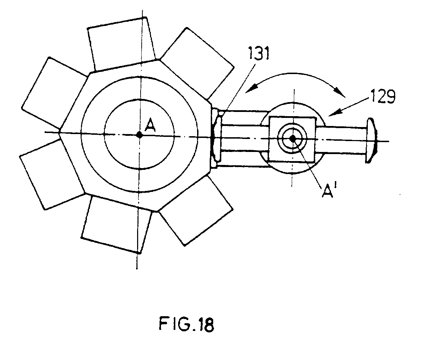

Es bezeichnet 105 einen Werkstückträger, der (siehe Fig. 11) um die Achse A getrieben drehbeweglich - ω - gelagert ist und innerhalb oder (siehe Fig. 18, A') ausserhalb der Kammer.

Der Werkstückträger 105 ist weiter bezüglich Achse A radial getrieben verschieblich, H.

Damit der Werkstückträger 105 überhaupt weitergedreht werden kann, muss er mindestens um $H_{min}$ von der Fläche 102 abgehoben werden.

Es gilt, gemäss Fig. 11 bzw. Fig. 7:

$$H_{min} = R_2 - R_1$$

$$= (\sqrt{R_1^2 + \rho^2}) - R_1$$

Hinzu zu $H_{min}$ tritt in der Praxis eine Hubgrösse $\Delta H$, die von Dichtsystem, Toleranzen und Sicherheitsabständen etc. abhängt.

Beträgt der Radius $R_2$ einer Zylinder-Kammer mit Achse A z.B. 150 mm und ρ des Werkstückträgers z.B. 70 mm, so ergibt sich $H_{min}$ zu 17 mm, wozu noch $\Delta H$ von z.B. 10 mm tritt.

Dieses bekannte und übliche Vorgehen führt, wie insbesondere aus Fig. 11 ersichtlich, dazu, dass der ebene Werkstückträger 105 um ein relativ grosses Hubmass H rückgeholt werden muss, damit er anschliessend durch eine Drehbewegung ω um die Achse A überhaupt zu einer weiteren der erwähnten Öffnungen in der Wand 101 geschwenkt werden kann.

Unter einem weiteren, für sich auch als erfinderisch betrachteten Aspekt der vorliegenden Erfindung, selbstverständlich mit all den vorerwähnten und vorbeschriebenen Merkmalen der bis anhin erläuterten Anlage kombinierbar, wird dieser Nachteil durch die in den Figuren 7 bis 9 bereits gezeigten und die noch zu beschreibenden Anlagen gelöst.

Die grundsätzliche Lösung dieses Problems sei vorerst anhand der Figuren 12 und 13 in Analogie zu den Figuren 10 und 11 dargestellt.

Die Umrandungsfläche 102' der Öffnung 103 ist nun ein Ausschnitt aus einer Rotationskörper-Mantelfläche mit Achse A, wie dargestellt z.B. einer Zylinderfläche.

Desgleichen ist die Umrandungsfläche des Werkstückträgers 105' ein Ausschnitt aus derselben Rotationskörper-Mantelfläche.

Wie sich aus Fig. 13 nun ergibt, mit Blick auch auf Fig. 11, wird:

$$R_2 = R_1$$

und es gilt, unabhängig von $\rho$, $H_{min} = R_2 - R_1 = 0$.

Es verbleibt $\Delta H$ als notwendiger Hub, der jedoch, gemäss zu Figuren 11, 12 gemachtem Beispiel, wesentlich geringer ist und deshalb noch geringer ausgelegt werden kann, weil der Hub an sich und damit gekoppeltes Spiel, Toleranzen etc. reduziert wird.

Die anhand der Figuren 12 und 13 vorgenommenen Betrachtungen treffen selbstverständlich auch dann zu, wenn nicht nur lediglich die die jeweilige Öffnung umrandende Fläche die Fläche eines Rotationskörpers definiert, sondern die ganze Kammerwand 101 im wesentlichen eine Rotationskörperfläche definiert.

Die Vakuumbehandlungsanlage gemäss den erwähnten Figuren, insbesondere den Figuren 7 bis 9, ist unter dem eben besprochenen Aspekt realisiert. Aus den Figuren 7 und 9 in Querschnitts-Darstellung bzw. aus Fig. 8 in Längsschnitt-Darstellung, ist ersichtlich, dass die Werkstückträger 80 in dem in Fig. 7 mit B umrandeten Bereich sowie die Umrandungsfläche der Öffnung 3 mindestens in erster Näherung entsprechend einer Zylindermantel-Ausschnittsfläche ausgebildet sind, so dass mit geringster Hubbewegung, radial bezüglich der Achse A, die Werkstückträger 80 abgehoben und weitergeschwenkt werden können.

Bei der Ausführungsform gemäss Fig. 9 entfallen Hubbewegungen gar gänzlich, die aktiven Dichtungen überbrücken dichtend den Spalt zwischen Werkstückträger (Karussell) und ÖffnungsUmrandung.

Bevorzugt wird, wie in Fig. 9 bereits dargestellt, die Öffnungs-Umrandungsfläche an einem auswechselbaren und in der Fertigung leicht handhabbaren Flansch 64' angeformt.

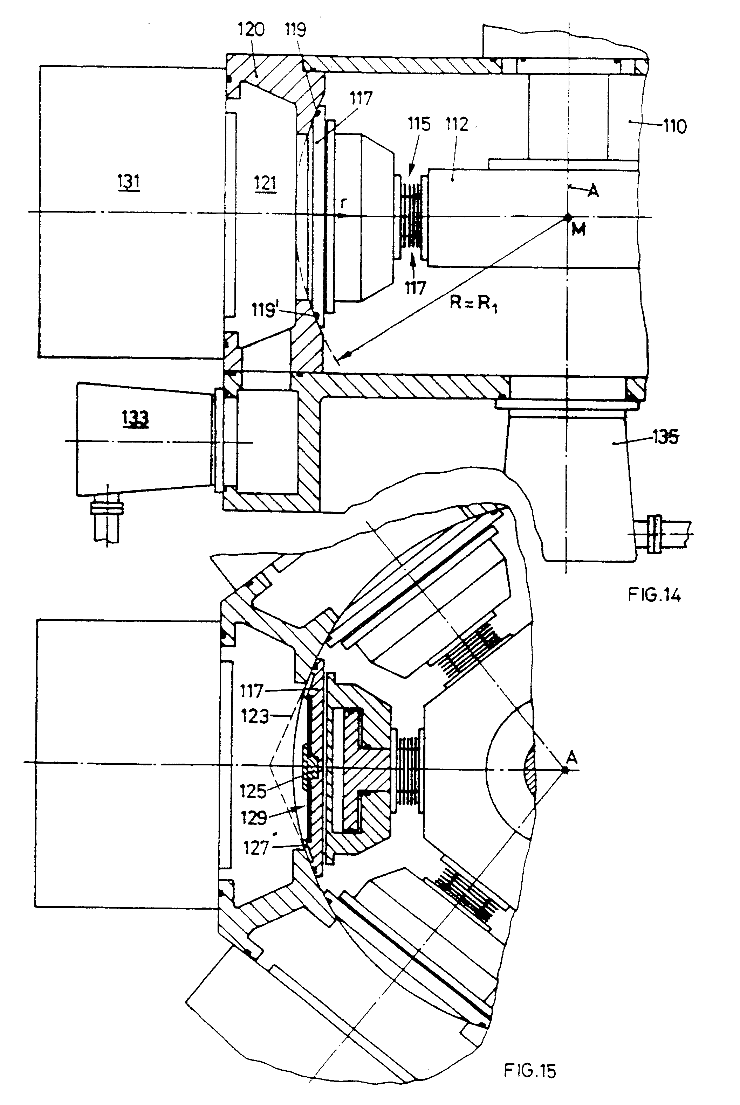

In den Figuren 14, in Längsschnitt-Darstellung, und 15, in Querschnitts-Darstellung, ist eine Kammer 110 dargestellt, welche bezüglich der Achse A bzw. des Mittelpunktes M einen Kugelflächenring mit dem Kugelradius R = $R_1$ festlegt. Die bezüglich der Achse A getrieben drehbare Transporteinrichtung 112 weist mehrere, im dargestellten Beispiel vier, radial wirkende Stössel 115 auf, je mit einem gekapselten Antrieb 117, welche Antriebe vorzugsweise unabhängig voneinander sind. Die endständig an den Stösseln 115 vorgesehenen Werkstückträger 117 weisen in ihrem Randbereich 119 mindestens. genähert die Form eines Ausschnittringes einer Kugelfläche mit Radius R auf, so, dass sie sich eng an die Umrandungsfläche der jeweiligen Öffnung 121, ebenfalls als Ausschnittring einer Kugelfläche mit Radius R ausgebildet, legen können.

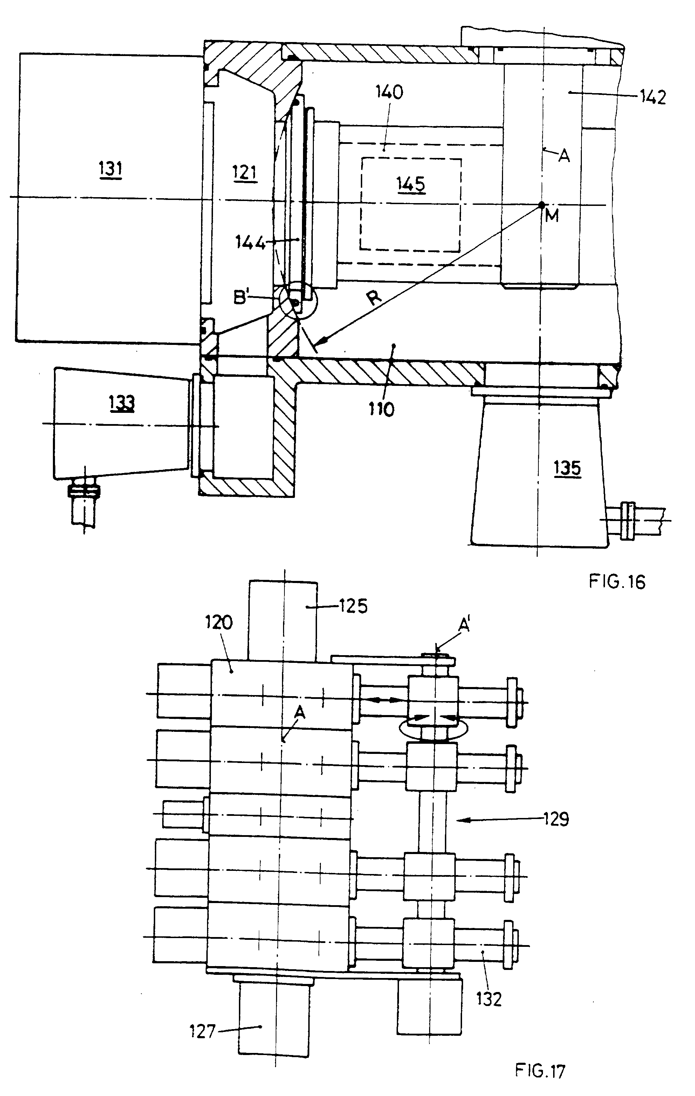

Entweder sind die Berandungsflächen der Werkstückträger 117 wie erwähnt kugelflächenringförmig, ober aber, genähert, wie in Fig. 15 bei 123 dargestellt, in Form eines Kegelringes ausgebildet, ausgeschnitten aus einem Tangentenkegel an den durch die Öffnungsumrandungsfläche aufgespannten Kugelflächenring. Auch letzterer kann gegebenenfalls genähert als Kegelflächenring eines Kegels, wie bei 123 dargestellt, ausgebildet sein. Wie insbesondere aus Fig. 15 ersichtlich, wird die Umrandungsfläche der Werkstückträger 117 zur Aufnahme kreisscheibenförmiger Werkstücke, mit einer Zentrumsmaskierung 125 gehalten, durch einen Peripherie-Maskierungungsring 127 für die Werkstücke 129 gebildet. Im weiteren ist in den Figuren 14 und 15 an der einen der Öffnungen 121 eine Behandlungs-, wie eine Sputterstation 131, dargestellt, weiter eine Pumpe 133 für die Sputterstation 131 und eine Pumpe 135 für die als Transportkammer ausgebildete Kammer 110.

Die Umrandungsfläche der Öffnung ist wiederum vorzugsweise in einen separaten Flansch 120 eingearbeitet. Auch hier können gegebenenfalls die Dichtungen 119' als aktive Dichtungen, hydraulisch oder, und dies bevorzugt, pneumatisch steuerbar ausgelegt sein.

Bei der Anlage gemäss Fig. 16 tragen Trägerarme 140 an einer Drehtransporteinrichtung 142 in der Kugelring-Kammer 110 gemäss Fig. 14 endständig Werkstückträger 144. Die Arme sind nicht radial ausfahrbar, lediglich um Achse A getrieben drehbar. In Analogie zu Fig. 9 sind die Dichtungen im Bereich B' als Spalt-überbrückende, aktive Dichtungen ausgebildet, z. B. gemäss Fig. 4 ausgelegt.

Weil kein Hub an den Armen 140 zu realisieren ist, können darin, als Hohlrohre ausgebildet, Aggregate, wie Werkstückträger-Antrieb - z.B. bei vorgesehenen Spaltdichtungen im Bereich B' - Mess-Aggregate, z.B. zur Temperaturmessung am Werkstück, Stellglieder, z. B. für die Werkstück-Beheizung oder Kühlung, elektrische und/oder Heiz-/Kühlmediumsleitungen etc. geführt bzw. angeordnet werden, wie dies schematisch in Fig. 16 bei 145 dargestellt ist.

Aufgrund der erfindungsgemäss realisierten Hubminimalisierung werden Hubrückholbewegungen H möglich - ohne Einsatz von aktiven Dichtungen - um die Transporteinrichtung 112 in der Ebene gemäss Fig. 15 oder um das Karussell 11 gemäss Fig. 7 weiterdrehen zu können, welche, bezüglich des Radius R der Rotationskörperfläche, die vom Werkstückträger bei seiner Drehung um die Achse definiert wird, folgenden Relationen genügen:

$r \leq 15$ % R,      bzw. bevorzugterweise

$r < 10$ % R,      vorzugsweise gar

$r \leq 5$ % R.

So wird bei einem Radius R = $R_1$ gemäss Fig. 14 von ca. 145 mm ein Abhebehub von weniger als 20 mm, vorzugsweise von weniger als 12 mm, oder gar von weniger als 8 mm möglich.

Damit wird es möglich, Werkstückträger mit grosser Ausdehnung ρ innerhalb kleindurchmessriger (R, $R_1$) Kammern durch Rotation um eine Kammerachse (A) zu transportieren, mit - wenn überhaupt - äusserst geringen Hubbewegungen. Die Hubbewegung (ΔH) wird unabhängig von der Werkstückträgergrösse ρ. Ohne definierbare untere Grenze wird vorzugsweise der Hub höchstens zu 20 % ρ, vorzugsweise zu höchstens 10 % ρ, oder gar zu höchstens 5 % ρ ausgelegt. Bei Vorsehen aktiver Dichtungen oder einer Spaltdichtung kann jeglicher Hub entfallen.

Mindestens die die Öffnungen umrandenden Kammerwand-Wandflächen definieren dabei mindestens in erster Näherung Zylinder- oder Kugelflächen, im genannten Sinne genähert gegebenenfalls durch Näherungsflächen, wie in Fig. 7 bei 123' bzw. in Fig. 15 bei 123 dargestellt. Entsprechend definieren die Berandungsflächen der Werkstückträger, wie insbesondere mit dem Peripheriemaskierungsring 127 in Fig. 15 ersichtlich, Kugelflächenringe oder, gemäss den Figuren 7 bis 9, Zylinderflächen-Ausschnitte, wiederum entweder exakt oder durch Annäherungssflächen, wie ebenfalls bei 123' bzw. 123 dargestellt, realisiert.

Bei einer Karussellanlage gemäss Fig. 7 können die Radialstössel fest auf die Öffnungen ausgerichtet sein oder ebenfalls bezüglich Achse A getrieben drehbeweglich.

Verglichen mit bezüglich Formgebung der Öffnungsumrandungsflächen und der Werkstückträger-Umrandungsflächen herkömmlichen Anlagen, wird es erfindungsgemäss möglich, den notwendigen Freigabehub für den Werkstückträger auf weniger als 25 % zu reduzieren. Aufgrund der nurmehr minimalen notwendigen Hube werden kürzere Taktzeiten ermöglicht, was wiederum zur Erhöhung des Durchsatzes an einer derartigen Anlage führt.

Wie sich aus Fig. 17 ergibt, können dabei aufgrund ihrer Kompaktheit mehrere erfindungsgemässe Vakuumkammern 121 modular gestapelt werden und beispielsweise durch einen gemeinsamen Antriebsmotor 125, eine gemeinsame Pumpe 127 und eine gemeinsame Handling-Roboter-Anordnung 129 betrieben bzw. bedient werden.

Selbstverständlich kann das Prinzip bezüglich Formgebung der Öffnungsumrandung und Formgebung der Werkstückträger-Umrandung auch, mit Blick auf Fig. 18, an einer Aussenfläche einer Vakuumkammer mit Bezug auf die Werkstückträger 131 eines aussenliegenden Handling-Roboters 129 realisiert werden, mit Stösseln gemäss Fig. 14, 15 oder - und bevorzugt - mit Trägerarmen 140 gemäss Fig. 16.

Die erfindungsgemässe Anlage weist somit, nebst den bereits erwähnten, folgende Vorteile auf:

- Wenig bewegte Teile mit kurzen Bewegungshuben, was die Zuverlässigkeit und Wartungsfreundlichkeit wesentlich erhöht;

- hohe Wirtschaftlichkeit bei Anlagenherstellung;

- hohe Durchsätze aufgrund kleiner durch die Werkstücke zurückzulegender Wege und kleiner zu bewegender Massen;

- für Mehrschichtsystem-Aufbringung äusserst geeignet aufgrund der gegenseitigen Abschotbarkeit der Behandlungskammern nach Mass;

- verschleissunabhängige, individuell einstellbar gesteuerte Dichtungen an den Bearbeitungsstationen;

- individuell zeit- und hubsteuerbare Stösselantriebe;

- höchst kompakte Bauweise.

Für die Behandlung kreisscheibenförmiger Werkstücke wird eine kugelringförmige Kammer gemäss den Figuren 14 bis 16 bevorzugt.

**Patentansprüche**

1. Vakuumbehandlungsanlage mit

(a) einem Aussengehäuse (1), das, um eine Achse A, eine im wesentlichen zylindrische Innenwand definiert,

(b) mindestens zwei Öffnungen (3) zur Behandlung oder für den Durchtransport jeweils eines Werkstückes (5), entlang mindestens eines Grosskreises (K) der zylindrischen Innenwand angeordnet,

(c) je einer Oberflächenbehandlungs-, Transport- oder Schleusenkammer (14), mit den Öffnungen (3) verbunden,

(d) einem Innengehäuse, eine im wesentlichen zylindrische Aussenwand definierend und mit der Innenwand des Aussengehäuses (1) einen im wesentlichen zylindrischen Ringspalt aufspannend,

(e) einem Werkstückträgerkarussell (11), im Ringspalt (9), um die Achse (A) drehgetrieben gelagert,

(f) einer Vorschubeinrichtung (16, 18), welche, am Innengehäuse (7) und ausgerichtet auf die Öffnungen, (3) radial getrieben bewegliche Mitnehmer (18, 22) umfasst, welche in den Ringspalt (9) wirken,

**dadurch gekennzeichnet, dass** jeder Mitnehmer (18, 22) einen eigenen Antrieb (16, 20) aufweist.

2. Vakuumbehandlungsanlage mindestens nach den Merkmalen (a) bis (c) von Anspruch 1 sowie mit einer Vorschubeinrichtung (16, 18) mit auf die Öffnungen (3) ausrichtbaren Werkstückaufnahmen, **dadurch gekennzeichnet, dass** für mindestens eine der Öffnungen (3) eine fluidgesteuerte, vorzugsweise pneumatisch oder hydraulisch gesteuerte Dichtungsanordnung (20, B; 30) vorgesehen ist, mittels welcher eine um die Öffnung (3) umlaufende Dichtung zwischen Öffnungsberandung und jeweils einer Werkstückaufnahme bzw. dem Werkstück (5) selber erstellt bzw. gelöst wird.

3. Anlage nach den Merkmalen der Ansprüche 1 und 2.

4. Anlage nach einem der Ansprüche 1 bis 3, **dadurch gekennzeichnet, dass** die Oberflächenbehandlungskammer eine Plasma-Oberflächenbehandlungskammer, vorzugsweise eine Zerstäubungskammer, insbesondere mit einer Magnetronquelle ist.

5. Vakuumbehandlungsanlage nach einem der Ansprüche 1, 3 oder 4, **dadurch gekennzeichnet, dass** die Mitnehmerantriebe fluidgetriebene, vorzugsweise pneumatische Antriebe sind, vorzugsweise bei denen der Mitnehmer zum Antriebsgehäuse balggekapselt (20) ist und der Balginnenraum als Druck-Antriebsraum wirkt.

6. Vakuumbehandlungsanlage nach einem der Ansprüche 1, 3, 4 oder 5, **dadurch gekennzeichnet, dass** die Mitnehmer (18, 22) direkt auf ein jeweiliges Werkstück (5) am Karussell oder auf einen am Karussel gelagerten Aufnahmeteller (80) für ein Werkstück (5) wirken.

7. Anlage nach Anspruch 6, **dadurch gekennzeichnet, dass** im Öffnungsbereich (3) mindestens einer der Öffnungen eine Dichtungsanordnung (B) vorgesehen ist, die, gesteuert, ein Dichten zwischen Öffnungsberandungsbereich und Werkstück selber und/oder zwischen Öffnungsberandungsbereich und einer Werkstückaufnahme (80) am Karussell (11) erstellt, gesteuert durch die Bewegung des Mitnehmers (18, 22).

8. Anlage nach einem der Ansprüche 6 oder 7, **dadurch gekennzeichnet, dass** am Karussell Aufnahmeteller (80) für die Werkstücke (5) vorgesehen sind, welche an einer Schleusenkammer, als Behandlungskammer, kammerseitiges Schleusenventil bilden.

9. Anlage nach Anspruch 5, **dadurch gekennzeichnet, dass** die Mitnehmer durch je mindestens einen elastischen druckbeaufschlagbaren Balg (20) gebildet sind.

10. Anlage nach einem der Ansprüche 2 oder 3, **dadurch gekennzeichnet, dass** um mindestens eine der Öffnungen (3) eine fluidgesteuerte, vorzugsweise pneumatisch oder hydraulisch expandierbare elastische Dichtung (30), insbesondere eine pneumatisch expandierbare vorgesehen ist, die sich bei Druckbeaufschlagung dicht an die Werkstückaufnahme (11) oder ein Werkstück (5) selber anlegt.

11. Anlage nach einem der Ansprüche 2 oder 3, **dadurch gekennzeichnet, dass** mindestens eine der Öffnungsberandungen und eine um eine Werkstückaufnahme oder ein Werkstück selber umlaufende Zone eine steuerbare Dichtung bilden und dass die Dichtungssteuerung mittels einer fluidgesteuerten, vorzugsweise pneumatischen oder hydraulischen, insbesondere pneumatischen Spanneinrichtung (20) erfolgt, mittels welcher, bei Druckbeaufschlagung, die Werkstückaufnahme, oder das Werkstück selber, dichtend gegen die Öffnungsberandung gespannt wird.

12. Anlage nach einem der Ansprüche 1 bis 11, **dadurch gekennzeichnet, dass** die Wandung des Aussengehäuses (1) im Öffnungsbereich (3) die Wand einer Schleusenkammer bildet oder den Prozessraum (70) einer Vakuumsbehandlungskammer.

13. Anlage nach einem der Ansprüche 1 bis 12, **dadurch gekennzeichnet, dass**, entlang mehrerer Grosskreise, Öffnungen angeordnet sind und das Karussell (11) zur Aufnahme von Werkstücken (5) entlang der entsprechenden Zahl Grosskreise ausgelegt ist oder axial beweglich ist.

14. Anlage nach einem der Ansprüche 1 bis 13, **dadurch gekennzeichnet, dass** topfförmige Werkstückträger (80) vorgesehen sind mit einem Randbereich entsprechend einem Zylinderflächenausschnitt.

15. Verwendung der Anlage nach einem der Ansprüche 1 bis 14 für das Beschichten von Werkstücken mit Mehrschichtsystemen.

16. Verwendung der Anlage nach einem der Ansprüche 1 bis 14 für die Herstellung von Speicherplatten.

17. Verwendung nach Anspruch 16 für die Bearbeitung von Halbleiter-Wafern, Speicherplatten, insbesondere von optischen Speicherplatten bzw. von CD, DVD, HD, insbesondere von wiederbespielbaren Speicherplatten, wie von MOD, Phase-Change-Disks oder RC (Recordable Disks).

18. Vakuumkammer mit mindestens einer Öffnung zum Durchtransport oder zur Behandlung mindestens eines Werkstückes

   • mit einer innerhalb oder ausserhalb der Kammer um eine Achse (A, A') getrieben drehbeweglichen Transporteinrichtung (11, 112, 129) mit mindestens einem Werkstückträgerteller (80, 117, 131) mit radial zur Drehachse (A, A') ausgerichteter Tellerachse, welcher mittels der Transporteinrichtung auf die Öffnung (3, 103, 121) ausrichtbar ist,

   • einer den Werkstückträgerteller umrandenden ersten Sitzfläche (123', 123), die, mindestens in erster Näherung, als Teilfläche einer Rotationskörper-Mantelfläche eines Rotationskörpers mit der Drehachse (A, A') als Achse ausgebildet ist,

   • einer die Öffnung (3, 103, 121) in der Kammer umrandenden zweiten Sitzfläche, die mit der ersten Sitzfläche, bei Ausrichtung des Werkstückträgertellers auf die Öffnung, parallel ist.

19. Kammer nach Anspruch 18, **dadurch gekennzeichnet, dass** die erste Sitzfläche ausgerichtet auf die zweite eine Spaltdichtung festlegen.

20. Kammer nach Anspruch 18 oder 19, **dadurch gekennzeichnet, dass** mindestens an einer der Sitzflächen eine fluidgesteuerte, vorzugsweise pneumatisch oder hydraulisch gesteuerte Dichtungsanordnung vorgesehen ist.

21. Kammer nach Anspruch 20, **dadurch gekennzeichnet, dass** die Dichtungsanordnung eine balgelastische und/oder materialelastische Dichtungsmembran umfasst.

22. Kammer nach einem der Ansprüche 18 bis 21, **dadurch gekennzeichnet, dass** mindestens ein, bezüglich der Achse (A, A') mindestens in einer Bewegungskomponente radial getrieben beweglicher Mitnehmer (76, 115, 132), der auf den Werkstückträgerteller wirkt, vorgesehen ist, wobei der Werkstückträgerteller, ausgerichtet auf die Öffnung, mittels des Mitnehmers zu dieser hin bzw. von dieser weg bewegbar ist.

23. Kammer nach einem der Ansprüch 18 bis 22, **dadurch gekennzeichnet, dass** der Rotationskörper eine Kugel oder ein Zylinder ist, vorzugsweise eine Kugel.

24. Kammer nach einem der Ansprüche 18 bis 23, **dadurch gekennzeichnet, dass** die Transporteinrichtung innerhalb der Vakuumkammer angeordnet ist.

25. Kammer nach einem der Ansprüche 22 bis 24, **dadurch gekennzeichnet, dass** der Mitnehmer radial einen Hub H ausführt, der bezüglich des Rotationskörper-Radius R folgenden Relationen genügt:

   $H \leq 15 \% R$, vorzugsweise
   $H \leq 10 \% R$, gar vorzugsweise
   $H \leq 5 \% R$.

26. Kammer nach einem der Ansprüche 18 bis 25, **dadurch gekennzeichnet, dass** der Werkstückträgerteller, ausgerichtet auf die Öffnung, bezüglich der Achse (A, A') radial um weniger als 20 % $\rho$, vorzugsweise um weniger als 10 % $\rho$, vorzugsweise gar um weniger als 5 % $\rho$ verschieblich ist, wobei 2 $\rho$ der Durchmesser des Werkstückträgertellers, in Achsrichtung betrachtet, ist.

27. Kammer nach einem der Ansprüche 18 bis 26, **dadurch gekennzeichnet, dass** die Transporteinrichtung durch ein Karussell gebildet ist, mit mindestens zwei Werkstückträgerteller, und dass mindestens zwei der Öffnungen vorgesehen sind.

28. Kammer nach einem der Ansprüche 18 bis 27 und Anspruch 22, **dadurch gekennzeichnet, dass** mindestens zwei bezüglich der Achse (A, A') drehfeste Mitnehmer vorgesehen sind oder mindestens ein, bezüglich der Achse (A, A') drehgelagerter und diesbezüglich getriebener Mitnehmer.

29. Kammer nach einem der Ansprüche 18 bis 28 und Anspruch 22, **dadurch gekennzeichnet, dass** der Mitnehmer an der Transporteinrichtung fixiert ist.

30. Kammer nach Anspruch 29, **dadurch gekennzeichnet, dass** die Transporteinrichtung und der Mitnehmer durch mindestens einen getrieben um die Achse (A, A') drehgetrieben gelagerten und diesbezüglich in mindestens einer Bewegungskomponente radial ausfahrbaren bzw. rückholbaren Arm mit endständigem Werkstückträgerteller gebildet ist.

31. Kammer nach einem der Ansprüche 18 bis 29 und Anspruch 22, **dadurch gekennzeichnet, dass** mehrere Mitnehmer je mit einem unabhängigen Antrieb vorgesehen sind.

32. Kammer nach einem der Ansprüche 18 bis 31, **da-**

**durch gekennzeichnet, dass** die Transporteinrichtung mindestens einen um die Achse drehgetrieben gelagerten, radialen Arm umfasst mit einem endständigen Werkstückträgerteller, und dass der Arm als Hohlkörper ausgebildet einen Aufnahmeraum für Aggregate bildet wie z.B. Mess- und/oder Stelleinrichtungen.

33. Kammer nach Anspruch 32, **dadurch gekennzeichnet, dass** der Werkstückträgerteller mehrere Werkstückaufnahmen umfasst und diese als Planeten eines endständigen Planetengetriebes ausgebildet sind.

34. Kammer nach einem der Ansprüche 18 bis 33, **dadurch gekennzeichnet, dass** der mindestens eine Werkstückträgerteller zur Aufnahme eines kreisscheibenförmigen Werkstückes ausgebildet ist und die erste Sitzfläche durch einen PeripherieMaskierungsring für das Werkstück gebildet ist.

35. Kammer nach Anspruch 34, **dadurch gekennzeichnet, dass** der Maskierungsring eine kegelringförmige Umrandungsfläche des Werkstückträgertellers definiert.

36. Kammer nach einem der Ansprüche 34 oder 35, **dadurch gekennzeichnet, dass** der Werkstückträgerteller einen Zentrumsmaskierungs-Zapfen für ein scheibenförmiges Werkstück mit Zentrumsloch umfasst.

37. Kammer nach einem der Ansprüche 18 bis 36, **dadurch gekennzeichnet, dass** die Kammer als Modul aufgebaut ist und mehrere der Kammern koaxial stapelbar sind, vorzugsweise mit einem gemeinsamen Antriebsmotor für die Transporteinrichtungen und weiter vorzugsweise einer gemeinsamen Pumpe für die Kammern.

38. Kammer nach einem der Ansprüche 18 bis 37, **dadurch gekennzeichnet, dass** sich die ersten und zweiten Sitzflächen dichtend, vorzugsweise vakuumdicht, aneinanderlegen.

39. Kammer nach einem der Ansprüche 18 bis 38, **dadurch gekennzeichnet, dass** die Sitzfläche der Öffnung an einem auswechselbaren Flansch gebildet ist.

40. Vakuumanlage nach einem der Ansprüche 1 bis 14 mit einer Vakuumkammer nach mindestens einem der Ansprüche 18 bis 39.

41. Verwendung der Kammer nach einem der Ansprüche 18 bis 39 bzw. der Anlage nach Anspruch 40 für das Beschichten von Werkstücken mit Mehrschicht-Systemen.

42. Verwendung der Kammer nach einem der Ansprüche 18 bis 39 bzw. der Anlage nach Anspruch 40 für die Bearbeitung von Halbleiter-Wafern oder von Speicherplatten, insbesondere von optischen Speicherplatten.

43. Verwendung der Kammer nach einem der Ansprüche 18 bis 39 bzw. der Anlage nach Anspruch 40 für die Herstellung von CD, DVD, HD, insbesondere von wiederbespielbaren Speicherplatten, wie von MOD, Phase Change Disks oder RC (Recordable Disks).

**Claims**

1. Vacuum treatment plant with

   (a) an outer housing (1) which defines about axis A an essentially cylindrical inner wall,
   (b) at least two openings (3) each for processing or through transport of a workpiece (5), arranged along at least one great circle (K) of the cylindrical inner wall,
   (c) a surface treatment chamber, transport chamber or lock chamber (14) respectively connected with the openings (3),
   (d) an inner housing defining an essentially cylindrical outer wall and, with the inner wall of the outer housing (1), clamping an essentially cylindrical annular gap,
   (e) a workpiece carrier carousel (11) mounted rotationally-driven about axis (A) in the annular gap (9),
   (f) a feed device (16, 18) which, on the inner housing (7) and aligned to the openings (3), comprises radially-driven mobile carriers (18, 22) which act in the annular gap (9),

   **characterised in that** each carrier (18, 22) has its own drive (16, 20).

2. Vacuum processing plant at least according to features (a) to (c) of claim 1 and with a feed device (16, 18) with workpiece holders which can be aligned to the openings (3), **characterised in that** for at least one of the openings (3) is provided a fluid-controlled, preferably pneumatically or hydraulically controlled, sealing device (20, B; 30) by means of which a seal is established or released surrounding the opening (3) between the opening edge and a workpiece holder or the workpiece (5) itself.

3. Plant according to the features of claims 1 and 2.

4. Plant according to any of claims 1 to 3, **characterised in that** the surface treatment chamber is a plasma surface treatment chamber, preferably a

21 **EP 0 946 780 B1** 22

sputtering chamber, in particular with a magnetron source.

5. Vacuum processing plant according to any of claims 1, 3 or 4, **characterised in that** the carrier drives are fluid-driven preferably pneumatic drives, preferably in which the carrier is bellows-encapsulated (20) to the drive housing and the interior of the bellows acts as a pressure drive chamber.

6. Vacuum processing plant according to any of claims 1, 3, 4 or 5, **characterised in that** the carriers (18, 22) each act directly on a workpiece (5) on the carousel or on a holder plate (80) for a workpiece (5) mounted on the carousel.

7. Plant according to claim 6, **characterised in that** in the opening area (3) of at least one of the openings is provided a seal arrangement (B) which, under control, establishes a seal between the opening edge area and the workpiece itself and/or between the opening edge area and a workpiece holder (80) on the carousel (11), controlled by the movement of the carrier (18, 22).

8. Plant according to any of claims 6 or 7, **characterised in that** on the carousel are provided holder plates (80) for the workpieces (5) which form, at a lock chamber, as treatment chamber, a lock valve on the chamber side.

9. Plant according to claim 5, **characterised in that** the carriers are formed by at least one elastic pressurizable bellows (20).

10. Plant according to any of claims 2 or 3, **characterised in that** about at least one of the openings (3) is provided a fluid-controlled, preferably pneumatically or hydraulically expandable elastic seal (30), in particular a pneumatically expandable seal which under pressurization rests tightly on the workpiece holder (11) or a workpiece (5) itself.

11. Plant according to any of claims 2 or 3, **characterised in that** at least one of the opening edges and a zone surrounding a workpiece holder or a workpiece itself form a controllable seal and that the seal is controlled by means of a fluid-controlled, preferably pneumatic or hydraulic, in particular pneumatic clamping device (20), by means of which on pressurization the workpiece holder or the workpiece itself is clamped tightly against the opening edge.

12. Plant according to any of claims 1 to 11, **characterised in that** the wall of the outer housing (1) in the opening area (3) forms the wall of a lock chamber or the process chamber (70) of a vacuum treatment chamber.

13. Plant according to any of claims 1 to 12, **characterised in that** openings are arranged along several great circles and the carousel (11) to hold workpieces (5) is arranged or is axially mobile along the corresponding number of great circles.

14. Plant according to any of claims 1 to 13, **characterised in that** pot-like workpiece carriers (80) are provided with an edge area corresponding to a cylinder surface section.

15. Use of the plant according to any of claims 1 to 14 for coating workpieces with multi-layer systems.

16. Use of the plant according to any of claims 1 to 14 for the production of memory disks.

17. Use according to claim 16 for the processing of semi-conductor wafers, memory disks, in particular optical memory disks or CD, DVD, HD, in particular rewritable memory disks such as MOD, phase change disks or RC (recordable disks).

18. Vacuum chamber with at least one opening for through transport or treatment of at least one workpiece

   - with a transport device (11, 112, 129) driven rotationally mobile about an axis (A, A') inside or outside the chamber, with at least one workpiece carrier plate (80, 117, 131) with plate axis aligned radial to the axis of rotation (A, A'), which can be aligned by means of the transport device to the opening (3, 103, 121),
   - a first seat (123', 123) surrounding the workpiece carrier plate and at least in a first approximation structured as a part surface of a rotational body generated surface of a rotational body with rotary axis (A, A') as an axis,
   - a second seat surrounding the opening (3, 103, 121) in the chamber and parallel to the first seat when the workpiece carrier plate is aligned to the opening.

19. Chamber according to claim 18, **characterised in that** the first seat aligned to the second defines a gap seal.

20. Chamber according to claim 18 or 19, **characterised in that** on at least one of the seats is provided a fluid-controlled, preferably pneumatically or hydraulically controlled, sealing arrangement.

21. Chamber according to claim 20, **characterised in that** the sealing arrangement comprises a bellows-elastic and/or material-elastic sealing membrane.

22. Chamber according to any of claims 18 to 21, **char-**

**acterised in that** at least one carrier (76, 115, 132) is provided which is mobile, radially driven in at least one movement component in relation to the axis (A, A') and which acts on the workpiece carrier plate, where the workpiece carrier plate aligned to the opening can be moved towards or away from this by means of the carrier.

23. Chamber according to any of claims 18 to 22, **characterised in that** the rotational body is a sphere or a cylinder, preferably a sphere.

24. Chamber according to any of claims 18 to 23, **characterised in that** the transport device is arranged inside the vacuum chamber.

25. Chamber according to any of claims 22 to 24, **characterised in that** the carrier radially performs a stroke H which in relation to the rotational body radius R fulfils the following relations:

$$H \leq 15\%R, \quad \text{preferably}$$
$$H \leq 10\%R, \quad \text{and preferably}$$
$$H \leq 5\%R.$$

26. Chamber according to any of claims 18 to 25, **characterised in that** the workpiece carrier plate aligned to the opening can be displaced in relation to axis (A, A') radially by less than 20 % $\rho$, preferably by less than 10 % $\rho$, preferably by less than 5 % p, where 2 $\rho$ is the diameter of the workpiece carrier plate viewed in the axial direction.

27. Chamber according to any of claims 18 to 26, **characterised in that** the transport device is formed by a carousel with at least two workpiece carrier plates and that at least two of the openings are provided.

28. Chamber according to any of claims 18 to 27 and claim 22, **characterised in that** at least two carriers rotationally fixed in relation to axis (A, A') are provided or at least one carrier rotationally mounted in relation to axis (A, A') and driven in relation to this.

29. Chamber according to any of claims 18 to 28 and claim 22, **characterised in that** the carrier is fixed to the transport device.

30. Chamber according to claim 29, **characterised in that** the transport device and the carrier are formed by at least one driven arm mounted rotationally driven about the axis (A, A') and in relation to this radially extendable or retractable in at least one movement component with an end-mounted workpiece carrier plate.

31. Chamber according to any of claims 18 to 29 and claim 22, **characterised in that** several carriers are provided each with an independent drive.

32. Chamber according to any of claims 18 to 31, **characterised in that** the transport device comprises at least one radial arm mounted rotationally driven about the axis, with an end-mounted workpiece carrier plate, and that the arm structured as a hollow body forms a holder chamber for devices e.g. measurement and/or adjustment devices.

33. Chamber according to claim 32, **characterised in that** the workpiece carrier plate comprises several workpiece holders and these are formed as planets of an end-mounted planet gear.

34. Chamber according to any of claims 18 to 33, **characterised in that** at least one workpiece carrier plate is formed to hold a circular disc-like workpiece and the first seat is formed by a peripheral masking ring for the workpiece.

35. Chamber according to claim 34, **characterised in that** the masking ring defines a tapered ring-shaped peripheral surface of the workpiece carrier plate.

36. Chamber according to any of claims 34 or 35, **characterised in that** the workpiece carrier plate comprises a centre masking pin for a disc-like workpiece with central hole.

37. Chamber according to any of claims 18 to 36, **characterised in that** the chamber is constructed modular and several chambers can be stacked coaxially, preferably with a common drive motor for the transport devices, and further preferably a common pump for the chambers.

38. Chamber according to any of claims 18 to 37, **characterised in that** the first and second seats rest on each other tightly, preferably vacuum-tight.

39. Chamber according to any of claims 18 to 38, **characterised in that** the seat of the opening is formed on an interchangeable flange.

40. Vacuum plant according to any of claims 1 to 14 with a vacuum chamber according to at least one of claims 18 to 39.

41. Use of the chamber according to any of claims 18 to 39 or the plant according to claim 40 for coating workpieces with multi-layer systems.

42. Use of the chamber according to any of claims 18 to 39 or the plant according to claim 40 for processing semi-conductor wafers or memory disks, in particular optical memory disks.

**43.** Use of the chamber according to any of claims 18 to 39 or the plant according to claim 40 for the production of CD, DVD, HD, in particular rewritable memory disks such as MOD, phase change disks or RC (recordable disks).

**Revendications**

**1.** Installation de traitement sous vide comportant :

(a) une enveloppe extérieure (1) qui définit autour d'un axe A une paroi intérieure globalement cylindrique,

(b) au moins deux ouvertures (3) qui sont prévues pour le traitement ou le passage de pièces respectives (5), le long d'au moins un grand cercle (K) de la paroi intérieure cylindrique,

(c) une chambre de traitement de surface, de transport ou formant sas (14) reliée à chaque ouverture (3),

(d) une enveloppe intérieure qui définit une paroi extérieure globalement cylindrique et qui forme avec la paroi intérieure de l'enveloppe extérieure (1) un espace annulaire globalement cylindrique,

(e) un carrousel porte-pièces (11) qui est monté, entraîné en rotation autour de l'axe (A), dans l'espace annulaire (9),

(f) un dispositif d'avance (16, 18) qui comprend des organes d'entraînement (18, 22) disposés sur l'enveloppe intérieure (7), alignés sur les ouvertures (3), mobiles radialement et agissant dans l'espace annulaire (9),

**caractérisée en ce que** chaque organe d'entraînement (18, 22) comporte un entraînement propre (16, 20).

**2.** Installation de traitement sous vide au moins selon les caractéristiques (a) à (c) de la revendication 1 et comportant un dispositif d'avance (16, 18) pourvu de porte-pièces aptes à être alignés sur les ouvertures (3),
**caractérisée en ce qu'**il est prévu pour l'une au moins des ouvertures (3) un dispositif d'étanchéité (20, B ; 30) commandé par fluide, de préférence par voie pneumatique ou hydraulique, grâce auquel une étanchéité est réalisée ou supprimée tout autour de l'ouverture (3), entre le bord de ladite ouverture et un porte-pièce ou la pièce (5) elle-même.

**3.** Installation selon les caractéristiques des revendications 1 et 2.

**4.** Installation selon l'une des revendications 1 à 3, **caractérisée en ce que** la chambre de traitement de surface est une chambre de traitement de surface par plasma, de préférence une chambre de pulvérisation, en particulier avec une source de magnétron.

**5.** Installation de traitement sous vide selon l'une des revendications 1, 3 ou 4, **caractérisée en ce que** les mécanismes d'entraînement des organes d'entraînement sont des mécanismes commandés par fluide, de préférence pneumatiques, de préférence avec lesquels l'organe d'entraînement est enfermé dans un soufflet (20) par rapport à l'enveloppe d'entraînement, et l'intérieur du soufflet agit comme un espace d'entraînement à pression.

**6.** Installation de traitement sous vide selon l'une des revendications 1, 3, 4 ou 5, **caractérisée en ce que** les organes d'entraînement (18, 22) agissent directement sur une pièce (5) au niveau du carrousel, ou sur un plateau (80) monté, pour une pièce (5), sur le carrousel.

**7.** Installation selon la revendication 6, **caractérisée en ce qu'**il est prévu, dans la zone d'ouverture (3) de l'une au moins des ouvertures, un dispositif d'étanchéité (B) qui, en étant commandé par le mouvement de l'organe d'entraînement (18, 22), réalise une étanchéité entre la zone du bord de l'ouverture et la pièce elle-même, et/ou entre la zone du bord de l'ouverture et un porte-pièce (80) sur le carrousel (11).

**8.** Installation selon la revendication 6 ou 7, **caractérisée en ce qu'**il est prévu, sur le carrousel, des plateaux (80) pour les pièces (5), qui forment sur une chambre formant sas, comme chambre de traitement, une soupape formant sas située côté chambre.

**9.** Installation selon la revendication 5, **caractérisée en ce que** chaque organe d'entraînement est formé par un soufflet élastique (20) apte à être sollicité par une pression.

**10.** Installation selon la revendication 2 ou 3, **caractérisée en ce qu'**il est prévu autour de l'une au moins des ouvertures (3) un joint d'étanchéité élastique (30) commandé par fluide, de préférence apte à se dilater par voie pneumatique ou hydraulique, en particulier pneumatique, qui, lorsqu'il est sollicité par une pression, s'applique tout seul de manière étanche contre le porte-pièce (11) ou contre une pièce (5) elle-même.

**11.** Installation selon la revendication 2 ou 3, **caractérisée en ce que** l'un au moins des bords d'ouvertures et une zone entourant un porte-pièce ou une pièce elle-même forment un joint d'étanchéité apte à être commandé, et **en ce que** la commande d'étanchéité se fait à l'aide d'un dispositif de serrage (20) commandé par fluide, de préférence pneumatique ou hydraulique, en particulier pneumatique, grâce auquel, lors d'une contrainte de pression, le porte-pièce ou la pièce elle-même est serré de manière étanche contre le bord de l'ouverture.

12. Installation selon l'une des revendications 1 à 11, **caractérisée en ce que** la paroi de l'enveloppe extérieure (1), dans la zone d'ouverture (3), forme la paroi d'une chambre formant sas ou l'espace de traitement (70) d'une chambre de traitement sous vide.

13. Installation selon l'une des revendications 1 à 12, **caractérisée en ce que** des ouvertures sont disposées le long de plusieurs grands cercles, et le carrousel (11) destiné à recevoir les pièces (5) est placé le long du nombre correspondant de grands cercles ou est axialement mobile.

14. Installation selon l'une des revendications 1 à 13, **caractérisée en ce qu'**il est prévu des porte-pièce en forme de coupelles (80), avec une zone de bordure correspondant à une découpe de surface cylindrique.

15. Utilisation de l'installation selon l'une des revendications 1 à 14 pour recouvrir des pièces à l'aide de systèmes multicouches.

16. Utilisation de l'installation selon l'une des revendications 1 à 14 pour fabriquer des disques de mémoire.

17. Utilisation selon la revendication 16 pour traiter des plaquettes de semi-conducteur, des disques de mémoire, en particulier des disques optiques ou des CD, DVD, disques durs, en particulier des disques de mémoire réenregistrables tels que des MOD, des disques à variation de phase ou des RC (disques enregistrables).

18. Chambre à vide avec au moins une ouverture pour le passage ou pour le traitement d'au moins une pièce, comportant

- un dispositif de transport (11, 112, 129) mobile en rotation autour d'un axe (A, A') à l'intérieur ou à l'extérieur de la chambre et comportant au moins un plateau porte-pièce (80, 117, 131) dont l'axe est dirigé radialement par rapport à l'axe de rotation (A, A') et qui est apte à être aligné sur l'ouverture (3, 103, 121) à l'aide du dispositif de transport,
- une première surface d'appui (123', 123) qui entoure le plateau porte-pièce et qui, du moins suivant une première approximation, est conçue comme une surface partielle d'une surface latérale d'un corps de rotation ayant comme axe l'axe de rotation (A, A'),

- une seconde surface d'appui qui entoure l'ouverture (3, 103, 121) dans la chambre et qui est parallèle à la première lorsque le plateau porte-pièce est aligné sur l'ouverture.

19. Chambre selon la revendication 18, **caractérisée en ce que** la première surface d'appui, alignée sur la seconde, bloque un joint à labyrinthe.

20. Chambre selon la revendication 18 ou 19, **caractérisée en ce qu'**il est prévu sur l'une au moins des surfaces d'appui un dispositif d'étanchéité commandé par fluide, de préférence par voie pneumatique ou hydraulique.

21. Chambre selon la revendication 20, **caractérisée en ce que** le dispositif d'étanchéité comprend une membrane d'étanchéité élastique grâce à un soufflet et/ou grâce au matériau.

22. Chambre selon l'une des revendications 18 à 21, **caractérisée en ce qu'**il est prévu au moins un organe d'entraînement (76, 115, 132) qui est mobile radialement par rapport à l'axe (A, A') au moins suivant une composante de mouvement et qui agit sur le plateau porte-pièce, ce dernier, lorsqu'il est aligné sur l'ouverture, pouvant être rapproché et éloigné de ladite ouverture grâce à l'organe d'entraînement.

23. Chambre selon l'une des revendications 18 à 22, **caractérisée en ce que** le corps de rotation est une sphère ou un cylindre, de préférence une sphère.

24. Chambre selon l'une des revendications 18 à 23, **caractérisée en ce que** le dispositif de transport est disposé à l'intérieur de la chambre à vide.

25. Chambre selon l'une des revendications 22 à 24, **caractérisée en ce que** l'organe d'entraînement décrit radialement une course H qui satisfait, pour le rayon de corps de rotation R, aux relations suivantes :

$$H \leq 15\ \%\ R, \qquad \text{de préférence}$$
$$H \leq 10\ \%\ R, \qquad \text{et plus particulièrement}$$
$$H \leq 5\ \%\ R.$$

26. Chambre selon l'une des revendications 18 à 25, **caractérisée en ce que** le plateau porte-pièce, aligné sur l'ouverture, est mobile radialement, par rapport à l'axe (A, A'), de moins de 20 % $\rho$, de préférence de moins de 10 % $\rho$ et de préférence de moins de 5 % $\rho$, 2$\rho$ étant le diamètre du plateau porte-pièce, considéré dans le sens axial.

**27.** Chambre selon l'une des revendications 18 à 26, **caractérisée en ce que** le dispositif de transport est formé par un carrousel avec au moins deux plateaux porte-pièce, et **en ce qu'**il est prévu au moins deux des ouvertures.

**28.** Chambre selon l'une des revendications 18 à 27 et 22, **caractérisée en ce qu'**il est prévu au moins deux organes d'entraînement fixes en rotation par rapport à l'axe (A, A'), ou au moins un organe d'entraînement monté en rotation par rapport à l'axe (A, A') et entraîné pour cela.

**29.** Chambre selon l'une des revendications 18 à 28 et 22, **caractérisée en ce que** l'organe d'entraînement est fixé au dispositif de transport.

**30.** Chambre selon la revendication 29, **caractérisée en ce que** le dispositif de transport et l'organe d'entraînement sont formés par un bras qui est monté mobile en rotation autour de l'axe (A, A') et apte à être déployé et rétracté radialement pour cela suivant au moins une composante de mouvement, et qui présente à son extrémité un plateau porte-pièce.

**31.** Chambre selon l'une des revendications 18 à 29 et 22, **caractérisée en ce qu'**il est prévu plusieurs organes d'entraînement comportant chacun un mécanisme d'entraînement indépendant.

**32.** Chambre selon l'une des revendications 18 à 31, **caractérisée en ce que** le dispositif de transport comprend au moins un bras radial monté en rotation autour de l'axe et présentant à son extrémité un plateau porte-pièce, et **en ce que** le bras, conçu comme un corps creux, forme un logement pour des unités comme des dispositifs de mesure et/ou de réglage, par exemple.

**33.** Chambre selon la revendication 32, **caractérisée en ce que** le plateau porte-pièce comprend plusieurs porte-pièce, et ceux-ci sont conçus comme les satellites d'un mécanisme planétaire prévu côté extrémité.

**34.** Chambre selon l'une des revendications 18 à 33, **caractérisée en ce que** le ou les plateaux porte-pièce sont conçus pour recevoir une pièce en forme de disque, et la première surface d'appui est formée par un anneau de masquage périphérique pour la pièce.

**35.** Chambre selon la revendication 34, **caractérisée en ce que** l'anneau de masquage définit une surface de bordure annulaire conique du plateau porte-pièce.

**36.** Chambre selon la revendication 34 ou 35, **caractérisée en ce que** le plateau porte-pièce comprend un tourillon de masquage central pour une pièce en forme de disque avec un trou central.

**37.** Chambre selon l'une des revendications 18 à 36, **caractérisée en ce que** la chambre est conçue comme un module, et plusieurs des chambres sont empilables coaxialement, de préférence avec un moteur d'entraînement commun pour les dispositifs de transport, et de préférence avec une pompe commune pour les chambres.

**38.** Chambre selon l'une des revendications 18 à 37, **caractérisée en ce que** les première et seconde surfaces d'appui sont appliquées l'une contre l'autre de manière étanche, de préférence étanche au vide.

**39.** Chambre selon l'une des revendications 18 à 38, **caractérisée en ce que** la surface d'appui de l'ouverture est formée sur une collerette échangeable.

**40.** Installation à vide selon l'une des revendications 1 à 14, avec une chambre à vide selon l'une au moins des revendications 18 à 39.

**41.** Utilisation de la chambre selon l'une des revendications 18 à 39 ou de l'installation selon la revendication 40 pour recouvrir des pièces avec des systèmes multicouches.

**42.** Utilisation de la chambre selon l'une des revendications 18 à 39 ou de l'installation selon la revendication 40 pour traiter des plaquettes de semiconducteur ou des disques de mémoire, en particulier des disques optiques.

**43.** Utilisation de la chambre selon l'une des revendications 18 à 39 ou de l'installation selon la revendication 40 pour fabriquer des CD, DVD, disques durs, en particulier des disques de mémoire réenregistrables tels que des MOD, des disques à variation de phase ou des RC (disques enregistrables).

FIG.1

FIG.2

FIG.3

FIG.4

FIG.5

FIG.6

EP 0 946 780 B1

FIG.7

20

FIG.8

FIG.9

FIG.10
Stand der Technik

FIG.11
Stand der Technik

EP 0 946 780 B1

FIG.12

FIG.13

24

FIG.14

FIG.15

FIG.16

FIG.17

FIG.18